# EUROPEAN PATENT SPECIFICATION

(11) **EP 3 493 227 B1**
(45) Date of publication and mention of the grant of the patent: **25.01.2023**
(21) Application number: 17846323.8
(22) Date of filing: 25.08.2017
(51) Int. Cl.: H01F 17/00, H01F 17/04, H02M 3/158, H02M 3/335, H01F 27/29

(54) **INDUCTOR COMPONENT AND POWER SUPPLY MODULE**
INDUKTORKOMPONENTE UND STROMVERSORGUNGSMODUL
COMPOSANT D'INDUCTEUR ET MODULE D'ALIMENTATION ÉLECTRIQUE

(30) Priority: 02.09.2016 JP 2016171464
(43) Date of publication of application: 05.06.2019
(73) Proprietor: Murata Manufacturing Co., Ltd., Nagaokakyo-shi, Kyoto 617-8555 (JP)
(72) Inventor: MIYASHITA, Munetake, Nagaokakyo-shi Kyoto 617-8555 (JP); TANGE, Takayuki, Nagaokakyo-shi Kyoto 617-8555 (JP); HASHI, Hideaki, Nagaokakyo-shi Kyoto 617-8555 (JP)
(74) Representative: Herrmann, Uwe
(86) International application number: PCT/JP2017/030482
(87) International publication number: WO 2018/043318

(56) References cited:
- EP-A2- 2 544 368
- WO-A1-2004/021374
- WO-A1-2005/060093
- JP-A- 2003 059 722
- JP-A- 2013 243 330
- JP-A- 2014 168 038
- JP-A- 2016 046 390
- JP-B2- 2 909 122
- US-A- 4 322 698
- US-A- 5 572 180
- US-A1- 2010 148 905
- US-A1- 2010 171 579
- US-A1- 2012 327 625
- US-A1- 2013 049 730
- US-A1- 2014 203 398
- US-A1- 2015 235 753
- US-A1- 2016 164 417

## Description

### Technical Field

The present invention relates to an inductor component including a plurality of inductors, and a power supply module using the inductor component.

### Background Art

Various types of inductor components are currently used. For example, an inductor component disclosed in Patent Document 1 includes a core substrate and a coil. The core substrate is formed, for example, by a printed circuit board. The coil is formed by a conductor and includes an upper-side wiring pattern, a lower-side wiring pattern, and interlayer connection conductors. The upper-side wiring pattern and the lower-side wiring pattern are printed patterns.

The upper-side wiring pattern is formed on the upper surface of the core substrate, and the lower-side wiring pattern is formed on the lower surface of the core substrate. The upper-side wiring pattern and the lower-side wiring pattern are connected by the interlayer connection conductors to form a helical coil.

### Citation List

### Patent Document

Patent Document 1: Japanese Unexamined Patent Application Publication No. 2000-40620.
US 2010/148905 A1 relates to an inductor module including a coil section provided with an input terminal and an output terminal. At least one of the input terminal and the output terminal is composed of a plurality of terminals. The input terminal and the output terminal are connected at different positions. The connection of the plurality of terminals constituting the input terminal or the output terminal is switched so as to change the combination of the input terminal and the output terminal, obtaining different inductance values.
US 5 572 180 A discloses a multi-tapped surface mount inductor providing high quality factor (Q) and high inductance being capable of being surface mounted on any of its four sides. An inner substrate layer(s) is provided with metallized patterns and vias to form a multi-turn coil.
JP 2 909122 B2 relates to a laminated inductor having a ferrite body with coil patterns which form a helical coil by metal pins.
EP 2 544 368 A2 relates to an electronic filter having a capacitor with first planar internal electrodes in electrical contact with a first termination and second planar internal electrodes in electrical contact with a second termination. A dielectric is between the first planar internal electrodes and the second planer internal electrodes. A third termination is provided and a conductive trace on a surface of the capacitor is between the third termination and the first termination. A ferromagnetic material is coupled to the conductive trace. Sintering of the capacitor can be followed by formation of the components with inductance properties.
US 2015/235753 A1 shows an inductor formed of metal plates interconnected by metal pins with two core members separated by a gap.

### Summary of Invention

### Technical Problem

Because of sophistication of electronic devices in recent years, the inductor component with the configuration described above may not be able to provide satisfactory characteristics.

In the configuration of the inductor component described in Patent Document 1 and US 2015 235753 A1, one inductor component includes only one inductor. This means that for an electronic device which requires a plurality of inductors, as many inductor components as required for the electronic device need to be prepared. In this case, due to characteristic variation among inductor components, a module which uses a plurality of inductor components may not be able to achieve required characteristics.

Accordingly, an object of the present invention is to provide an inductor component including a plurality of inductors, enable each inductor to achieve good inductor characteristics, and reduce characteristic variation among the inductors.

### Solution to Problem

The inductor component as defined in independent claim 1. In particular, such an inductor component includes a core member having an upper surface and a lower surface; a coil disposed in the core member; and a first terminal electrode, a second terminal electrode, and a third terminal electrode. The coil includes a plurality of first metal plates, which are spaced apart from each other and disposed on the upper surface of the core member, a plurality of second metal plates, which are spaced apart from each other and disposed on the lower surface of the core member, and a plurality of metal pins. The coil is formed into a helical shape by connecting the plurality of first metal plates to the plurality of second metal plates, with the plurality of metal pins therebetween. The first terminal electrode, the third terminal electrode, and the second terminal electrode are spaced apart in this order along a direction in which the helical shape of the coil extends, and are connected to the coil.

This configuration, in which the coil includes the metal plates and the metal pins integrally formed, reduces variation among inductor components and improves characteristics, such as DCR. A first inductor is formed between the first terminal electrode and the second terminal electrode, and a second inductor is formed between the second terminal electrode and the third terminal electrode. The above-described structure enables a plurality of inductors to be integrally formed, and the above-described structure can be formed by metal molding. This reduces characteristic variation between the plurality of inductors.

The inductor component according to the present invention is configured as follows. The core member is divided into a first core member and a second core member, wherein the first core member and the second core member are spaced apart in the direction in which the helical shape of the coil extends.

With this configuration, a plurality of inductors which are not coupled together by a magnetic field are integrally formed.

According to an example not forming part of the invention, the core member is not divided.

With this configuration, a plurality of inductors which are coupled together by a magnetic field could be integrally formed.

According to the invention, two of the plurality of the metal pins are inserted into a gap between the first core member and the second core member. The remaining ones of the plurality of the metal pins pass through the core member in a thickness direction. The two of the plurality of the metal pins are connected to one of the second plurality of metal plates at two predetermined position on said metal plate. the third terminal electrode is formed in the middle of the one of the second plurality of metal plates in a direction in which said second metal plate extends.

The inductor component according to the embodiment of the present invention is preferably configured as follows. The first terminal electrode, the second terminal electrode, and the third terminal electrode are columnar electrodes connected to the second metal plate and extending in a direction orthogonal to the lower surface of the core member.

This configuration improves mountability of the inductor component.

A power supply module according to an embodiment of the present invention includes the inductor component described above, a circuit board having a predetermined pattern formed thereon, a power supply control IC, and a switching element. The inductor component, the power supply control IC, and the switching element are mounted on the circuit board. The switching element is disposed near one of the first terminal electrode, the second terminal electrode, and the third terminal electrode of the inductor component, the one being a terminal electrode to which the switching element is connected.

This configuration reduces the connection distance between the inductor component and the switching element.

In the power supply module according to the embodiment of the present invention, it is preferable that the switching element and the inductor component be at least partially superimposed in plan view.

This configuration reduces the planar area of the power supply module.

### Advantageous Effects of Invention

The present invention reduces variation among inductor components, improves characteristics such as DCR, and reduces characteristic variation between a plurality of inductors.

### Brief Description of Drawings

[Fig. 1] Fig. 1 is an exploded perspective view of an inductor component according to a first embodiment of the present invention.
[Fig. 2] Fig. 2 is an external perspective view of the inductor component according to the first embodiment of the present invention.
[Fig. 3] Fig. 3 is an exploded perspective view of an inductor component according to an example not forming part of the invention.
[Fig. 4] Fig. 4 is an external perspective view of the inductor component according to an example not forming part of the invention.
[Fig. 5] Fig. 5 is a circuit diagram of a power supply module according to a second embodiment of the present invention.
[Fig. 6] Fig. 6 is a circuit diagram of a power supply module according to an example not forming part of the invention.
[Fig. 7] Fig. 7 is a circuit diagram of a power supply module according to an example not forming part of the present invention.
[Fig. 8] Fig. 8 is a circuit diagram of a power supply module according to an example not forming part of the present invention.
[Fig. 9] Fig. 9 is an external perspective view schematically illustrating a configuration of a power supply module according to an example not forming part of the invention.

### Description of Embodiments and Examples

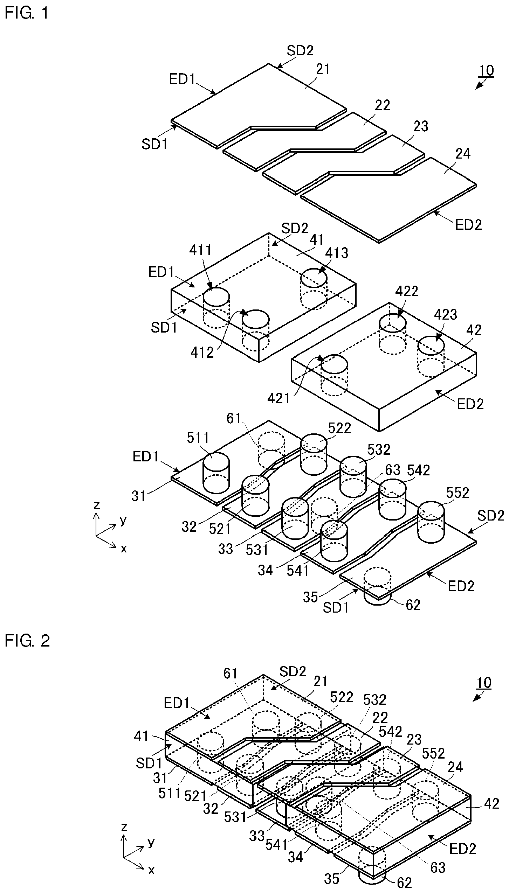

An inductor component according to a first embodiment of the present invention will be described with reference to the drawings. Fig. 1 is an exploded perspective view of the inductor component according to the first embodiment of the present invention. Fig. 2 is an external perspective view of the inductor component according to the first embodiment of the present invention.

As illustrated in Figs. 1 and 2, an inductor component 10 includes first metal plates 21, 22, 23, and 24, second metal plates 31, 32, 33, 34, and 35, core members 41 and 42, metal pins 511, 521, 522, 531, 532, 541, 542, and 552, and terminal electrodes 61, 62, and 63.

The core members 41 and 42 are substantially in the shape of a rectangular parallelepiped with upper and lower surfaces. The core members 41 and 42 are, for example, resin substrates. The core members 41 and 42 do not necessarily need to resin substrates, as long as they are made of a material having a predetermined relative magnetic permeability. It is preferable, however, that the core members 41 and 42 be made of a material which enables easy formation of through-holes therein.

The core member 41 and the core member 42 are spaced apart in the x-direction in Figs. 1 and 2. In other words, the core member 41 and the core member 42 are formed by dividing one core member in the middle in the x-direction. The core member 41 is on the side of a first end face ED1 of the inductor component 10, and the core member 42 is on the side of a second end face ED2 of the inductor component 10. A first side face SD1 of the core member 41 is substantially flush with a first side face SD1 of the core member 42, and a second side face SD2 of the core member 41 is substantially flush with a second side face SD2 of the core member 42.

The core member 41 has through-holes 411, 412, and 413 therethrough from the upper surface thereof to the lower surface thereof. The through-holes 411 and 412 are formed near the first side face SD1 of the core member 41 and spaced apart in a direction parallel to the first side face SD1 (i.e., in the x-direction in Figs. 1 and 2). The through-hole 413 is formed near the second side face SD2 of the core member 41. In the x-direction, the position of the through-hole 412 is substantially the same as the position of the through-hole 413. The through-hole 411 is formed on a side of the core member 41 adjacent to the first end face ED1 in the x-direction, whereas the through-holes 412 and 413 are formed on the other side of the core member 41 adjacent to the second end face ED2 in the x-direction.

The core member 42 has through-holes 421, 422, and 423 therethrough from the upper surface thereof to the lower surface thereof. The through-hole 421 is formed near the first side face SD1 of the core member 42. The through-holes 422 and 423 are formed near the second side face SD2 of the core member 42 and spaced apart in a direction parallel to the first side face SD1 (i.e., in the x-direction in Figs. 1 and 2). In the x-direction, the position of the through-hole 421 is substantially the same as the position of the through-hole 422. The through-holes 421 and 422 are formed on a side of the core member 42 adjacent to the first end face ED1 in the x-direction, whereas the through-hole 423 is formed on the other side of the core member 42 adjacent to the second end face ED2 in the x-direction.

The first metal plates 21, 22, 23, and 24 are disposed on the upper surface of the core members 41 and 42, or more specifically, in the upper plane of a rectangular parallelepiped region forming the core members 41 and 42. The first metal plate 21, the first metal plate 22, the first metal plate 23, and the first metal plate 24 are arranged in this order along the x-direction, from the first end face ED1 toward the second end face ED2 of the inductor component 10. The first metal plate 21, the first metal plate 22, the first metal plate 23, and the first metal plate 24 are spaced apart from each other. The first metal plate 21 is narrower on the side of the first side face SD1 than on the side of the second side face SD2. The first metal plate 24 is wider on the side of the first side face SD1 than on the side of the second side face SD2. The first metal plates 22 and 23 have a uniform width in an extension direction in which they extend. The first metal plates 22 and 23 bend in the middle in the extension direction.

The second metal plates 31, 32, 33, 34, and 35 are disposed on the lower surface of the core members 41 and 42, or more specifically, in the lower plane of the rectangular parallelepiped region occupied by the core members 41 and 42. The second metal plate 31, the second metal plate 32, the second metal plate 33, the second metal plate 34, and the second metal plate 35 are arranged in this order along the x-direction, from the first end face ED1 toward the second end face ED2 of the inductor component 10. The second metal plate 31, the second metal plate 32, the second metal plate 33, the second metal plate 34, and the second metal plate 35 are spaced apart from each other. The second metal plate 31 is wider on the side of the first side face SD1 than on the side of the second side face SD2. The second metal plate 35 is narrower on the side of the first side face SD1 than on the side of the second side face SD2. The second metal plates 32, 33, and 34 have a uniform width in an extension direction in which they extend. The second metal plates 32, 33, and 34 bend in the middle in the extension direction.

The metal pin 511 is inserted in the through-hole 411. The metal pin 511 connects a predetermined position in the second metal plate 31 adjacent to the first side face SD1 to a predetermined position in the first metal plate 21 adjacent to the first side face SD1.

The metal pin 522 is inserted in the through-hole 413. The metal pin 522 connects a predetermined position in the first metal plate 21 adjacent to the second side face SD2 to a predetermined position in the second metal plate 32 adjacent to the second side face SD2.

The metal pin 521 is inserted in the through-hole 412. The metal pin 521 connects a predetermined position in the second metal plate 32 adjacent to the first side face SD1 to a predetermined position in the first metal plate 22 adjacent to the first side face SD1.

The metal pin 532 is inserted in the gap between the core member 41 and the core member 42. The metal pin 532 connects a predetermined position in the first metal plate 22 adjacent to the second side face SD2 to a predetermined position in the second metal plate 33 adjacent to the second side face SD2.

The metal pin 531 is inserted in the gap between the core member 41 and the core member 42. The metal pin 531 connects a predetermined position in the second metal plate 33 adjacent to the first side face SD1 to a predetermined position in the first metal plate 23 adjacent to the first side face SD1.

The metal pin 542 is inserted in the through-hole 422. The metal pin 542 connects a predetermined position in the first metal plate 23 adjacent to the second side face SD2 to a predetermined position in the second metal plate 34 adjacent to the second side face SD2.

The metal pin 541 is inserted in the through-hole 421. The metal pin 541 connects a predetermined position in the second metal plate 34 adjacent to the first side face SD1 to a predetermined position in the first metal plate 24 adjacent to the first side face SD1.

The metal pin 552 is inserted in the through-hole 423. The metal pin 552 connects a predetermined position in the first metal plate 24 adjacent to the second side face SD2 to a predetermined position in the second metal plate 35 adjacent to the second side face SD2.

This configuration enables the first metal plates 21, 22, 23, and 24, the second metal plates 31, 32, 33, 34, and 35, and the metal pins 511, 521, 522, 531, 532, 541, 542, and 552 to form a helical coil. The core members 41 and 42 are substantially entirely disposed inside the coil. The core members 41 and 42 may be partially disposed outside the coil.

The inductor component 10 thus provides a configuration in which a first inductor including the core member 41 and a second inductor including the core member 42 are integrally formed. This provides the inductor component 10 in which variation in characteristics, such as DCR, between the first inductor and the second inductor is reduced. The characteristic variation between the first inductor and the second inductor is further reduced particularly when the first metal plates 21, 22, 23, and 24, the second metal plates 31, 32, 33, 34, and 35, and the metal pins 511, 521, 522, 531, 532, 541, 542, and 552 are molded in a metal mold or are formed integrally.

This configuration can reduce resistivity of the first metal plates 21, 22, 23, and 24, the second metal plates 31, 32, 33, 34, and 35, and the metal pins 511, 521, 522, 531, 532, 541, 542, and 552, and can reduce the DCR of the inductor component 10. This enables both the first inductor and the second inductor to achieve good inductor characteristics.

The terminal electrodes 61, 62, and 63 are columnar in shape, as are the metal pins described above. The terminal electrode 61 is formed on a surface of the second metal plate 31 opposite the core member 41. The terminal electrode 61 is formed near the second side face SD2 of the second metal plate 31. The terminal electrode 62 is formed on a surface of the second metal plate 35 opposite the core member 42. The terminal electrode 62 is formed near the first side face SD1 of the second metal plate 35. The terminal electrode 63 is formed on a surface of the second metal plate 33 opposite the core members 41 and 42. The terminal electrode 63 is formed in the middle of the second metal plate 33 in a direction in which the second metal plate 33 extends.

This configuration enables the terminal electrodes 61 and 63 to serve as terminals of the first inductor including the core member 41, and enables the terminal electrodes 62 and 63 to serve as terminals of the second inductor including the core member 42. This configuration improves mountability of the inductor component 10, because the terminal electrodes 61, 62, and 63 protrude from the back surface of the inductor component 10 in a direction (z-direction) orthogonal to the back surface.

Forming the terminal electrodes 61, 62, and 63 similarly to the metal pins can reduce the resistivity of the terminal electrodes 61, 62, and 63.

The terminal electrodes 61, 62, and 63 are only required to be arranged at intervals in the order of the terminal electrode 61, the terminal electrode 63, and the terminal electrode 62 along the direction in which the helical coil extends. That is, by appropriately positioning the terminal electrode 61, the terminal electrode 63, and the terminal electrode 62, the first inductor and the second inductor can be adjusted to a desired inductance value.

Although the terminal electrodes 61, 62, and 63 are formed on the back surface of the inductor component 10 in the embodiment described above, a part of the terminal electrodes 61 and 62 (e.g., terminal electrode 62) may be formed on the front surface of the inductor component 10.

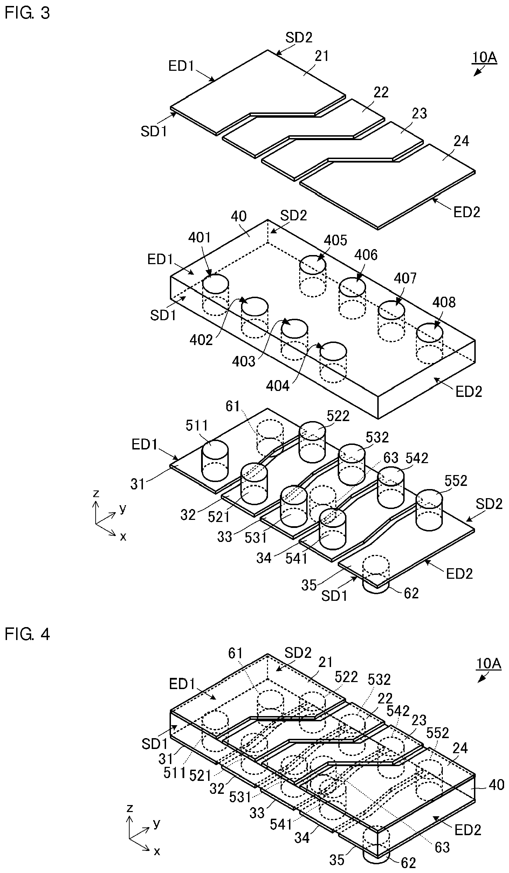

Fig. 3 is an exploded perspective view of the inductor component according to an example not forming part of the invention. Fig. 4 is an external perspective view of the inductor component according to the example not forming part of the invention.

An inductor component 10A according to the present example differs from the inductor component 10 according to the first embodiment in that the inductor component 10A includes only one core member 40. Other than that, the inductor component 10A has the same configuration as the inductor component 10 of the first embodiment, and the description of the same parts will be omitted.

The core member 40 is in the shape of a rectangular parallelepiped with upper and lower surfaces. The core member 40 extends continuously from the first end face ED1 to the second end face ED2 of the inductor component 10A.

The core member 40 has through-holes 401, 402, 403, 404, 405, 406, 407, and 408 therethrough from the upper surface thereof to the lower surface thereof. The through-holes 401, 402, 403, and 404 are formed near the first side face SD1 of the core member 40 and spaced apart in a direction parallel to the first side face SD1 (i.e., in the x-direction in Figs. 3 and 4). The through-holes 401, 402, 403, and 404 are arranged in this order along the x-direction, from the first end face ED1 toward the second end face ED2.

The through-holes 405, 406, 407, and 408 are formed near the second side face SD2 of the core member 40 and spaced apart in a direction parallel to the second side face SD2 (i.e., in the x-direction in Figs. 3 and 4). The through-holes 405, 406, 407, and 408 are arranged in this order along the x-direction, from the first end face ED1 toward the second end face ED2.

The metal pin 511 is inserted in the through-hole 401, the metal pin 521 is inserted in the through-hole 402, the metal pin 531 is inserted in the through-hole 403, and the metal pin 541 is inserted in the through-hole 404.

The metal pin 522 is inserted in the through-hole 405, the metal pin 532 is inserted in the through-hole 406, the metal pin 542 is inserted in the through-hole 407, and the metal pin 552 is inserted in the through-hole 408.

With this configuration, the first inductor using the terminal electrode 61 and the terminal electrode 63 as input and output terminals and the second inductor using the terminal electrode 62 and the terminal electrode 63 as input and output terminals are integrally formed. The first inductor and the second inductor are coupled by a magnetic field. That is, the inductor component 10A provides a configuration in which the first inductor and the second inductor coupled by a magnetic field are integrally formed. Even with this configuration having magnetic field coupling, characteristic variation between the first inductor and the second inductor can be reduced and both the first inductor and the second inductor can achieve good inductor characteristics, as in the case of the inductor component 10 of the first embodiment.

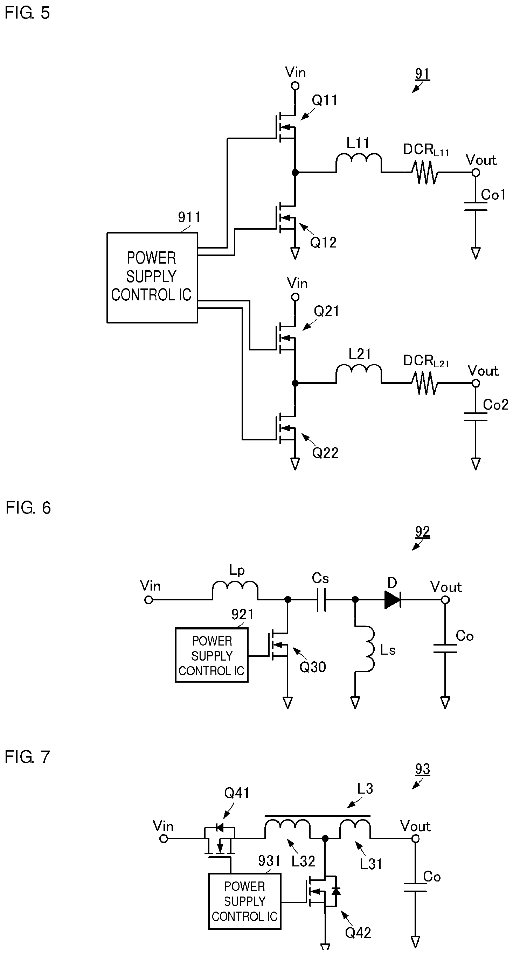

A power supply module according to a second embodiment will now be described with reference to the drawing. Fig. 5 is a circuit diagram of the power supply module according to the second embodiment of the present invention.

As illustrated in Fig. 5, a power supply module 91 includes a power supply control IC 911, switching elements Q11, Q12, Q21, and Q22, inductors L11 and L21, and output capacitors Co1 and Co2. The inductor L11 and the inductor L21 each contain a direct-current resistance (DCR) component. In an equivalent circuit, DCR_{L11} of the inductor L11 is connected in series to the inductor L11, and DCR_{L21} of the inductor L21 is connected in series to the inductor L21.

The switching element Q11 and the switching element Q12 are connected between a voltage input terminal Vin and the ground. The switching element Q11 and the switching element Q12 are connected to the power supply control IC 911. The switching element Q11 and the switching element Q12 are switching-controlled by the power supply control IC 911.

The inductor L11 is connected to a switching node to which the switching element Q11 and the switching element Q12 are connected, and the resulting series circuit is connected to a voltage output terminal Vout. The output capacitor Co1 is connected between the voltage output terminal Vout and the ground.

The switching element Q21 and the switching element Q22 are connected between a voltage input terminal Vin and the ground. The switching element Q21 and the switching element Q22 are connected to the power supply control IC 911. The switching element Q21 and the switching element Q22 are switching-controlled by the power supply control IC 911.

The inductor L21 is connected to a switching node to which the switching element Q21 and the switching element Q22 are connected, and the resulting series circuit is connected to a voltage output terminal Vout. The output capacitor Co2 is connected between the voltage output terminal Vout and the ground.

This configuration enables the power supply module 91 to provide a multiphase converter which includes a first power stage on the side of the inductor L11 and a second power stage on the side of the inductor L21. The inductor component 10 described above is used in the inductor L11 and the inductor L21. For example, the first inductor of the inductor component 10 serves as the inductor L11, and the second inductor of the inductor component 10 serves as the inductor L21.

This reduces variation in DCR between the inductor L11 and the inductor L21. Therefore, it is possible to enhance accuracy of sensing a current in the inductor L11 and the inductor L21, maintain current balance between a plurality of power stages (multiple phases) with high accuracy, and improve the characteristics of the power supply module 91.

Since inductance variation between the inductor L11 and the inductor L21 can be reduced, it is possible to reduce variation in inductor current and improve the characteristics of the power supply module 91.

Using the inductor component 10 enables a large current to pass through the inductor L11 and the inductor L21 and makes it possible to support applications designed for large current.

Because of high flexibility in positioning the terminal electrodes 61 and 62, it is possible to reduce the distance between the switching node between the switching elements Q11 and Q12 and the inductor L11 and the distance between the switching node between the switching elements Q21 and Q22 and the inductor L21, and improve resistance of the power supply module 91 to noise.

Also, it is possible to easily achieve commonality of the voltage output terminals Vout between the power stages and simplify the configuration of the power supply module 91.

Fig. 6 is a circuit diagram of the power supply module according to an example not forming part of the invention.

As illustrated in Fig. 6, a power supply module 92 includes a power supply control IC 921, a switching element Q30, inductors Lp and Ls, a capacitor Cs, a diode D, and an output capacitor Co.

A series circuit of the inductor Lp, the capacitor Cs, and the inductor Ls is connected between the voltage input terminal Vin and the ground. The switching element Q30 is connected between a node between the inductor Lp and the capacitor Cs and the ground. The power supply control IC 921 is connected to the switching element Q30. The switching element Q30 is switching-controlled by the power supply control IC 921.

The anode of the diode D is connected to a node between the capacitor Cs and the inductor Ls, and the cathode of the diode D is connected to the voltage output terminal Vout. The output capacitor Co is connected between the voltage output terminal Vout and the ground.

This configuration enables the power supply module 92 to provide a SEPIC converter. The inductor component 10A described above is used in the inductor Lp and the inductor Ls. For example, the first inductor of the inductor component 10A serves as the inductor Lp and the second inductor of the inductor component 10A serves as the inductor Ls.

It is preferable that characteristic variation between the inductor Lp and the inductor Ls of the SEPIC converter be small. Using the inductor component 10A to provide the inductors Lp and Ls thus enables the power supply module 92 to achieve good characteristics.

Fig. 7 is a circuit diagram of the power supply module according to an example not forming part of the invention.

As illustrated in Fig. 7, a power supply module 93 includes a power supply control IC 931, switching elements Q41 and Q42, an inductor L3, and the output capacitor Co. The inductor L3 includes an inductor L31 and an inductor L32 coupled to each other.

A series circuit of the switching element Q41, the inductor L32, and the switching element Q42 is connected between the voltage input terminal Vin and the ground. The power supply control IC 931 is connected to the switching elements Q41 and Q42. The switching elements Q41 and Q42 are switching-controlled by the power supply control IC 931. The inductor L32 is connected to the inductor L31 on a side thereof adjacent to the switching element Q42. In other words, the switching element Q42 is connected between a node between the inductor L32 and the inductor L31 and the ground. The inductor L31 is connected to the voltage output terminal Vout. The output capacitor Co is connected between the voltage output terminal Vout and the ground.

This configuration enables the power supply module 93 to provide a power supply module which uses a tapped inductor. The inductor component 10A described above is used in the inductor L3. For example, the second inductor of the inductor component 10A serves as the inductor L31, and the first inductor of the inductor component 10A serves as the inductor L32.

This configuration enables the power supply module 93 to easily provide a power supply module which offers high flexibility in setting a center tap position, that is, an inductance ratio between the inductor L32 and the inductor L31. Specifically, for example, by positioning the first metal plate, the second metal plate, and the terminal electrodes to set the winding ratio and the way of winding of the first inductor and the second inductor, the inductance ratio between the inductor L32 and the inductor L31 can be flexibly and easily set. Using the inductor component 10A enables the power supply module 93 to be used in applications designed for large current. The power supply module 93 can be used in up-converters or down-converters which have a large difference in voltage between input and output.

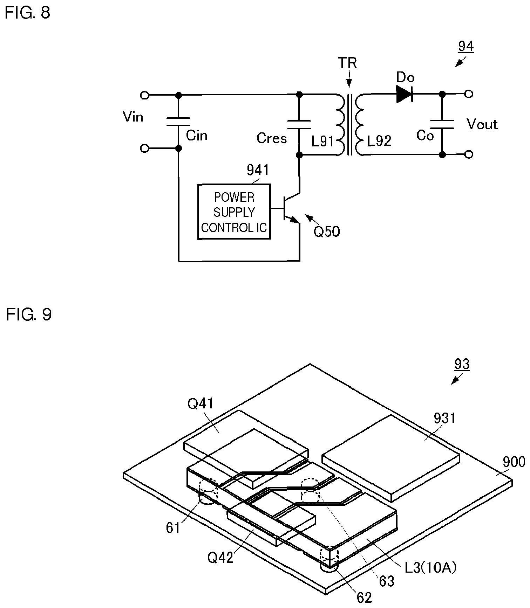

A power supply module according to an example that does not form part of the present invention will now be described with reference to the drawing. Fig. 8 is a circuit diagram of the power supply module according to this example.

As illustrated in Fig. 8, a power supply module 94 includes a power supply control IC 941, a switching element Q50, an isolated transformer TR, a resonance capacitor Cres, an output-side diode Do, an input capacitor Cin, and the output capacitor Co. The isolated transformer TR includes a primary coil L91 and a secondary coil L92.

A series circuit composed of the primary coil L91 of the isolated transformer TR and the switching element Q50 is connected between a first end and a second end of the voltage input terminal Vin. The resonance capacitor Cres is connected in parallel to the primary coil L91. The input capacitor Cin is connected between the first end and the second end of the voltage input terminal Vin. A first end of the voltage output terminal Vout is connected to one end of the secondary coil L92 of the isolated transformer TR, with the output-side diode Do therebetween, and a second end of the voltage output terminal Vout is connected to the other end of the secondary coil L92. The power supply control IC 941 is connected to the switching element Q50. The switching element Q50 is switching-controlled by the power supply control IC 941.

This configuration enables the power supply module 94 to provide an isolated DC converter. The inductor component 10A described above is used in the isolated transformer TR. For example, the first inductor of the inductor component 10A serves as the primary coil L91, and the second inductor of the inductor component 10A serves as the secondary coil L92.

This configuration enables the power supply module 94 to easily provide a power supply module which offers high flexibility in setting an inductance ratio between the primary coil L91 and the secondary coil L92. Specifically, for example, by positioning the first metal plate, the second metal plate, and the terminal electrodes to set the winding ratio and the way of winding of the first inductor and the second inductor of the inductor component 10A, the inductance ratio between the primary coil L91 and the secondary coil L92 can be flexibly and easily set. Using the inductor component 10A enables the power supply module 94 to be used in applications designed for large current.

A conventional configuration of the isolated transformer TR requires consideration of the degree of coupling between the primary coil and the secondary coil made by a core, such as an EI or EE core, and requires adjustment during manufacture. Using the inductor component 10A makes it possible to achieve, without requiring such adjustment, a desired degree of coupling between the primary coil and the secondary coil.

Each of the power supply modules described above can be formed by a structure, such as that illustrated in Fig. 9. Fig. 9 is an external perspective view schematically illustrating a configuration of a power supply module according to an example not forming part of the invention. Fig. 9 only shows components which represent characteristic features of the example not forming part of the invention, and does not show the other components. Although Fig. 9 shows the power supply module 93, the same configuration is also applicable to the other power supply modules and, in particular, also to the power supply module 91 of Fig. 5, which shows the second embodiment of the present invention.

As illustrated in Fig. 9, the power supply module 93 includes a circuit board 900, the switching elements Q41 and Q42, the inductor component 10A, and the power supply control IC 931. The switching elements Q41 and Q42, the inductor component 10A, and the power supply control IC 931 are surface-mounted electronic components mounted on the surface of the circuit board 900. The circuit illustrated in Fig. 7 is obtained by mounting the switching elements Q41 and Q42, the inductor component 10A, the power supply control IC 931, and other components (not shown).

The terminal electrodes 61, 62, and 63 of the inductor component 10A are connected to conductor patterns on the surface of the circuit board 900. The switching element Q41 is connected to the conductor pattern to which the terminal electrode 61 is connected. The conductor pattern to which the terminal electrode 62 is connected is connected to the voltage output terminal Vout (not shown). The conductor pattern to which the terminal electrode 63 is connected is connected to the switching element Q42.

In plan view of the circuit board 900, at least part of the switching element Q41 and at least part of the switching element Q42 are superimposed on the inductor component 10A. The switching element Q41 and the switching element Q42 are disposed on the back side of the inductor component 10A. It is particularly preferable, as illustrated in Fig. 9, that the switching element Q42 be substantially superimposed on the inductor component 10A.

This can reduce the physical distance and the connection distance between the terminal electrode 63 of the inductor component 10A and the switching element Q42, and can improve resistance of the power supply module 93 to noise. Also, the power supply module 93 can be reduced in size in plan view.

Although an inductor component is applied to a power supply module in the explanation described above, it may be applied to an electric or electronic circuit component including a plurality of inductors.

For example, the inductor component 10A is applicable to a common mode choke coil. This can be achieved by a configuration which divides one of the first metal plate and the second metal plate, or a configuration which divides a metal pin or removes one of a plurality of metal pins. With this configuration of the inductor component, a common mode choke coil having good characteristics can be provided.

The inductor component and the power supply module according to the present invention have been described on the basis of the embodiments. The present invention is only defined by the appended claims.

### Reference Signs List

10, 10A: inductor component
21, 22, 23, 24: first metal plate
31, 32, 33, 34, 35: second metal plate
40, 41, 42: core member
61, 62, 63: terminal electrode
91, 92, 93, 94: power supply module
401 to 408, 411 to 413, 421 to 423: through-hole
511, 521, 522, 531, 532, 541, 542, 552: metal pin
900: circuit board
Cin: input capacitor
Co: output capacitor
Co1: output capacitor
Co2: output capacitor
Cres: resonance capacitor
Cs: capacitor
D: diode
Do: output-side diode
ED1: first end face
ED2: second end face
IC: for power supply control
911, 921, 931, 941: power supply control IC
L11, L12, L21, L3, L31, L32, Lp, Ls: inductor
L91: primary coil
L92: secondary coil
Q11, Q12, Q21, Q22, Q30, Q41, Q42, Q50: switching element
DCR_{L11}, DCR_{L12}: direct-current resistance of inductor
SD1: first side face
SD2: second side face
TR: isolated transformer
Vin: voltage input terminal
Vout: voltage output terminal

## Claims

1. An inductor component (10) comprising:
a core member (41, 42) having an upper surface and a lower surface;
a coil disposed in the core member (41, 42); and
a first terminal electrode (61), a second terminal electrode (62), and a third terminal electrode (63),
wherein the coil includes
a plurality of first metal plates (21, 22, 23, 24), which are spaced apart from each other and disposed on the upper surface of the core member (41, 42),
a plurality of second metal plates (31, 32, 33, 34), which are spaced apart from each other and disposed on the lower surface of the core member (41, 42), and
a plurality of metal pins (511, 521, 522, 531, 532, 541, 542, 552);
the coil is formed into a helical shape by connecting the plurality of first metal plates (21, 22, 23, 24) to the plurality of second metal plates (31, 32, 33, 34), with the plurality of metal pins (511, 521, 522, 531, 532, 541, 542, 552) therebetween; and
the first terminal electrode (61), the third terminal electrode (63), and the second terminal electrode (62) are spaced apart in this order along a direction in which the helical shape of the coil extends, and are connected to the coil,
**characterized in that** the core member (41, 42) is divided into a first core member (41) and a second core member (42), wherein the first core member (41) and the second core member (42) are spaced apart in the direction in which the helical shape of the coil extends, thereby forming a gap between the first core member (41) and the second core member (42),
wherein two of the plurality of metal pins (531, 532) are inserted into the gap
wherein the remaining ones of the plurality of the metal pins (511, 521, 522, 541, 542, 552) pass through the core member (41, 42) in a thickness direction,
wherein the two of the plurality of metal pins (531, 532) are connected to one (33) of the second plurality of metal plates at two predetermined positions on said metal plate,
and wherein the third terminal electrode (63) is formed in the middle of the one (33) of the second plurality of metal plates in a direction in which said second metal plate (33) extends.

2. The inductor component (10) according to Claim 1, wherein the first terminal electrode (61), the second terminal electrode (62), and the third terminal electrode (63) are columnar electrodes connected to the plurality of second metal plates (31, 32, 33, 34) and extending in a direction orthogonal to the lower surface of the core member (41, 42).

3. A power supply module (91) comprising:
the inductor component (10) according to Claim 2;
a circuit board (900) having a plurality of conductor patterns formed thereon;
a power supply control IC (911); and
a switching element (Q11, Q12, Q21, Q22), wherein the inductor component (10), the power supply control IC (911), and the switching element (Q11, Q12, Q21, Q22) are mounted on the circuit board (900); and
the switching element (Q11, Q12, Q21, Q22) is connected to the conductor pattern to which one of the first terminal electrode (61), the second terminal electrode (62) and the third terminal electrode (63) of the inductor component (10) is connected.

4. The power supply module (91) according to Claim 3, wherein the switching element (Q11, Q12, Q21, Q22) and the inductor component (10) are at least partially superimposed in a plan view of the circuit board (900).

## Patentansprüche

1. Induktorbauteil (10), aufweisend:
ein Kernelement (41, 42) mit einer Oberseite und einer Unterseite;
eine in dem Kernelement (41, 42) angeordnete Spule; und
eine erste Anschlusselektrode (61), eine zweite Anschlusselektrode (62) und eine dritte Anschlusselektrode (63),
wobei die Spule aufweist:
eine Vielzahl erster Metallplatten (21, 22, 23, 24), die voneinander beabstandet sind und auf der Oberseite des Kernelements (41, 42) angeordnet sind,
eine Vielzahl zweiter Metallplatten (31, 32, 33, 34), die voneinander beabstandet sind und auf der Unterseite des Kernelements (41, 42) angeordnet sind, und
eine Vielzahl von Metallstiften (511, 521, 522, 531, 532, 541, 542, 552);
die Spule durch Verbinden der Vielzahl von ersten Metallplatten (21, 22, 23, 24) mit der Vielzahl von zweiten Metallplatten (31, 32, 33, 34) mit der Vielzahl von Metallstiften (511, 521, 522, 531, 532, 541, 542, 552) dazwischen in einer helikalen ausgebildet ist; und
die erste Anschlusselektrode (61), die dritte Anschlusselektrode (63) und die zweite Anschlusselektrode (62) in dieser Reihenfolge entlang einer Richtung voneinander beabstandet sind, in der sich die helikale Form der Spule erstreckt, und mit der Spule verbunden sind,
**dadurch gekennzeichnet, dass** das Kernelement (41, 42) in ein erstes Kernelement (41) und ein zweites Kernelement (42) unterteilt ist, wobei das erste Kernelement (41) und das zweite Kernelement (42) in der Richtung voneinander beabstandet sind, in der sich die helikale Form der Spule erstreckt, wodurch zwischen dem ersten Kernelement (41) und dem zweiten Kernelement (42) ein Spalt gebildet wird,
wobei zwei der Vielzahl von Metallstiften (531, 532) in den Spalt eingesetzt sind,
wobei der Rest der Vielzahl von Metallstiften (511, 521, 522, 541, 542, 552) in einer Dickenrichtung durch das Kernelement (41, 42) verlaufen,
wobei die zwei der Vielzahl von Metallstiften (531, 532) mit einer (33) der zweiten Vielzahl von Metallplatten an zwei vorbestimmten Positionen auf der genannten Metallplatte verbunden sind,
und wobei die dritte Anschlusselektrode (63) in der Mitte der einen (33) der zweiten Vielzahl von Metallplatten in einer Richtung, in der sich die genannte zweite Metallplatte (33) erstreckt, gebildet ist.

2. Induktorbauteil (10) nach Anspruch 1,
wobei die erste Anschlusselektrode (61), die zweite Anschlusselektrode (62) und die dritte Anschlusselektrode (63) säulenförmige Elektroden sind, die mit der Vielzahl von zweiten Metallplatten (31, 32, 33, 34) verbunden sind und sich in einer zu der Unterseite des Kernelements (41, 42) orthogonalen Richtung erstrecken.

3. Stromversorgungsmodul (91), aufweisend:
das Induktorbauteil (10) nach Anspruch 2;
eine Leiterplatte (900) mit einer Vielzahl von darauf gebildeten Leiterstrukturen;
eine Stromversorgungssteuerungs-IC (911); und
ein Schaltelement (Q11, Q12, Q21, Q22),
wobei das Induktorbauteil (10), die Stromversorgungssteuerungs-IC (911) und das Schaltelement (Q11, Q12, Q21, Q22) auf der Leiterplatte (900) montiert sind; und
das Schaltelement (Q11, Q12, Q21, Q22) mit der Leiterstruktur verbunden ist, mit der eine von der ersten Anschlusselektrode (61), der zweiten Anschlusselektrode (62) und der dritten Anschlusselektrode (63) des Induktorbauteils (10) verbunden ist.

4. Stromversorgungsmodul (91) nach Anspruch 3, wobei das Schaltelement (Q11, Q12, Q21, Q22) und das Induktorbauteil (10) einander in Draufsicht auf die Leiterplatte (900) zumindest teilweise überlagern.

## Revendications

1. Composant d'induction (10) comprenant :
un élément noyau (41, 42) comportant une surface supérieure et une surface inférieure ;
une bobine disposée dans l'élément noyau (41, 42) ; et
une première électrode de borne (61), une deuxième électrode de borne (62) et une troisième électrode de borne (63),
la bobine comprenant
une pluralité de premières plaques métalliques (21, 22, 23, 24), espacées les unes des autres et disposées sur la surface supérieure de l'élément noyau (41, 42),
une pluralité de secondes plaques métalliques (31, 32, 33, 34), espacées les unes des autres et disposées sur la surface inférieure de l'élément noyau (41, 42), et
une pluralité de broches métalliques (511, 521, 522, 531, 532, 541, 542, 552) ;
la bobine prend une forme hélicoïdale au moyen de la liaison de la pluralité de premières plaques métalliques (21, 22, 23, 24) à la pluralité de secondes plaques métalliques (31, 32, 33, 34), la pluralité de broches métalliques (511, 521, 522, 531, 532, 541, 542, 552) étant interposée entre lesdites plaques ; et
la première électrode de borne (61), la troisième électrode de borne (63) et la deuxième électrode de borne (62) étant espacées dans l'ordre le long d'une direction d'extension de la forme hélicoïdale de la bobine, et étant connectées à la bobine,
**caractérisé en ce que** l'élément noyau (41, 42) est divisé en un premier élément noyau (41) et un second élément noyau (42), le premier élément noyau (41) et le second élément noyau (42) étant espacés dans la direction d'extension de la forme hélicoïdale de la bobine, formant ainsi un espace entre le premier élément noyau (41) et le second élément noyau (42),
deux broches (531, 532), parmi la pluralité de broches métalliques, étant introduites dans l'espace,
les broches restantes (511, 521, 522, 541, 542, 552), parmi la pluralité de broches métalliques, passant à travers l'élément noyau (41, 42) dans la direction de l'épaisseur,
deux broches (531, 532), parmi la pluralité de broches métalliques, étant connectées à une plaque (33), parmi la seconde pluralité de plaques métalliques, au niveau de deux positions prédéfinies sur ladite plaque métallique,
et la troisième électrode de borne (63) étant formée au milieu de ladite plaque (33), parmi la seconde pluralité de plaques métalliques, dans une direction d'extension de ladite seconde plaque métallique (33).

2. Le composant d'induction (10) selon la Revendication 1, dans lequel la première électrode de borne (61), la deuxième électrode de borne (62) et la troisième électrode de borne (63) sont des électrodes colonnaires connectées à la pluralité de secondes plaques métalliques (31, 32, 33, 34) et s'étendant dans une direction orthogonale à la surface inférieure de l'élément noyau (41, 42).

3. Un module d'alimentation électrique (91) comprenant :
le composant d'induction (10) selon la Revendication 2 ;
une carte de circuit imprimé (900) comportant une pluralité de motifs conducteurs formés sur la carte ;
un CI (911) de commande d'alimentation électrique ; et
un élément de commutation (Q11, Q12, Q21, Q22),
le composant d'induction (10), le CI (911) de commande d'alimentation électrique et l'élément de commutation (Q11, Q12, Q21, Q22) étant montés sur la carte de circuit imprimé (900) ; et
l'élément de commutation (Q11, Q12, Q21, Q22) étant connecté au motif conducteur auquel une électrode, parmi la première électrode de borne (61), la deuxième électrode de borne (62) et la troisième électrode de borne (63) du composant d'induction (10), est connectée.

4. Le module d'alimentation électrique (91) selon la Revendication 3, dans lequel l'élément de commutation (Q11, Q12, Q21, Q22) et le composant d'induction (10) sont superposés, au moins partiellement, dans une vue en plan de la carte de circuit imprimé (900).
